(19) Europäisches Patentamt
European Patent Office
Office européen des brevets

(11) **EP 4 097 791 B1**

(12) **EUROPEAN PATENT SPECIFICATION**

(45) Date of publication and mention
of the grant of the patent:
**13.11.2024 Bulletin 2024/46**

(21) Application number: **21706032.6**

(22) Date of filing: **29.01.2021**

(51) International Patent Classification (IPC):
*H01P 7/06* (2006.01)    *H01J 27/18* (2006.01)
*H01P 11/00* (2006.01)    *H01J 37/32* (2006.01)
*H05H 7/18* (2006.01)    *H05H 7/08* (2006.01)

(52) Cooperative Patent Classification (CPC):
**H01P 11/008; H01J 27/18; H01J 37/32247;**
**H01P 7/06; H05H 7/18;** H05H 7/08; H05H 2007/082

(86) International application number:
**PCT/IB2021/050696**

(87) International publication number:
**WO 2021/152518 (05.08.2021 Gazette 2021/31)**

(54) **A MICROWAVE RESONATOR WITH EXCITATION BY DIFFRACTIVE APERTURES FOR ION SOURCES AND PLASMA TRAPS**

MIKROWELLENRESONATOR MIT ANREGUNG DURCH BEUGENDE APERTUREN FÜR IONENQUELLEN UND PLASMAFALLEN

RÉSONATEUR À MICRO-ONDES À EXCITATION PAR DES OUVERTURES DE DIFFRACTION DESTINÉ À DES SOURCES D'IONS ET DES PIÈGES À PLASMA

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.01.2020 IT 202000001756**

(43) Date of publication of application:
**07.12.2022 Bulletin 2022/49**

(73) Proprietor: **Istituto Nazionale di Fisica Nucleare 00044 Frascati (RM) (IT)**

(72) Inventors:
- **MASCALI, David**
  **95038 Santa Maria Di Licodia (Catania) (IT)**
- **TORRISI, Giuseppe**
  **95045 Misterbianco (Catania) (IT)**
- **LEONARDI, Ornella**
  **95030 Tremestieri Etneo (Catania) (IT)**
- **MAURO, Giorgio Sebastiano**
  **95024 Acireale (Catania) (IT)**

(74) Representative: **Metroconsult Srl et al Foro Bonaparte 51 20121 Milano (IT)**

(56) References cited:
**JP-A- 2003 045 698     US-B1- 7 305 935**

- **GIUSEPPE TORRISI ET AL: "Non-Conventional Microwave Coupling of RF Power in ECRIS Plasmas", ICIS 2017-17TH INTERNATIONAL CONFERENCE ON ION SOURCES, 16 October 2017 (2017-10-16), CERN-CICG-Geneva, XP055737894, Retrieved from the Internet <URL:https://indico.cern.ch/event/628126/contributions/2675499/attachments/1541107/2416777/mo_15.pdf> [retrieved on 20201008]**
- **V. MIRONOV ET AL: "Numerical model of electron cyclotron resonance ion source", PHYSICAL REVIEW SPECIAL TOPICS - ACCELERATORS AND BEAMS, vol. 18, no. 12, 1 December 2015 (2015-12-01), XP055737905, DOI: 10.1103/PhysRevSTAB.18.123401**

**Description**

This invention relates to microwave resonators for plasmas, used in particular in ion sources and plasma traps.

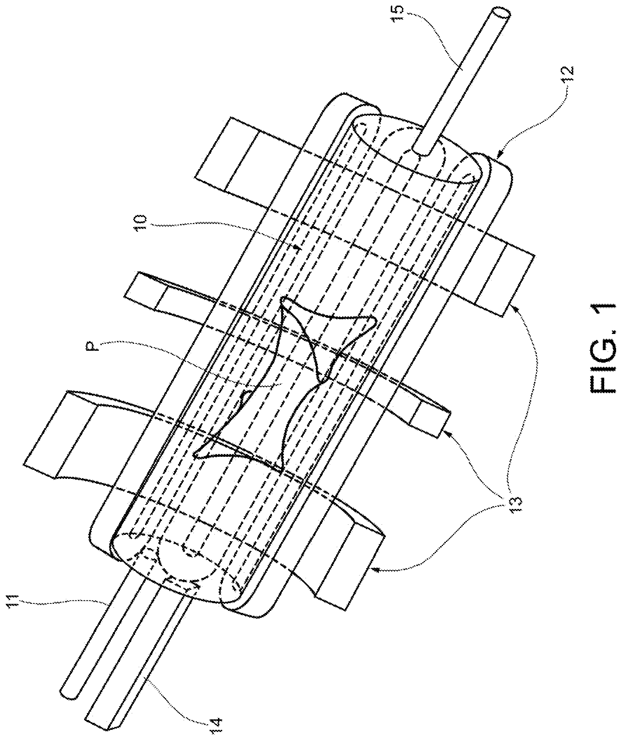

The operating principle of electron cyclotron resonance (ECR) ion sources is represented in Fig. 1, where 10 indicates a chamber made of metal material configured to contain a plasma P, and 11 indicates an inlet for the supply of gas to the chamber 10. Associated with the chamber 10 are a multipole 12, in particular a hexapole, and a solenoid 13, configured to generate respectively a radial component and an axial component of a magnetic field inside the chamber 10. Reference 14 indicates a waveguide configured to inject microwaves inside the chamber 10.

In an ECR ion source the power provided by the microwaves is combined with heating induced by electron cyclotron resonance in a plasma confined in a magnetic bottle in B-minimum configuration to produce ions.

It is known that electrons moving in a magnetic field revolve around the magnetic field lines due to the Lorentz force. The gyration frequency is known as the cyclotron frequency. If a microwave radiation propagates in such a region, electrons are accelerated or decelerated in a resonant manner (according to the phase of their transverse velocity component with respect to the electric field vector) when the following electron cyclotron resonance condition is satisfied:

$$\omega_f = \omega_c = (e/m)\cdot B,$$

where $\omega_f$ is the microwave frequency, $\omega_c$ is the electron cyclotron frequency, e and m are the charge and mass of the electron, and B is the local magnetic field.

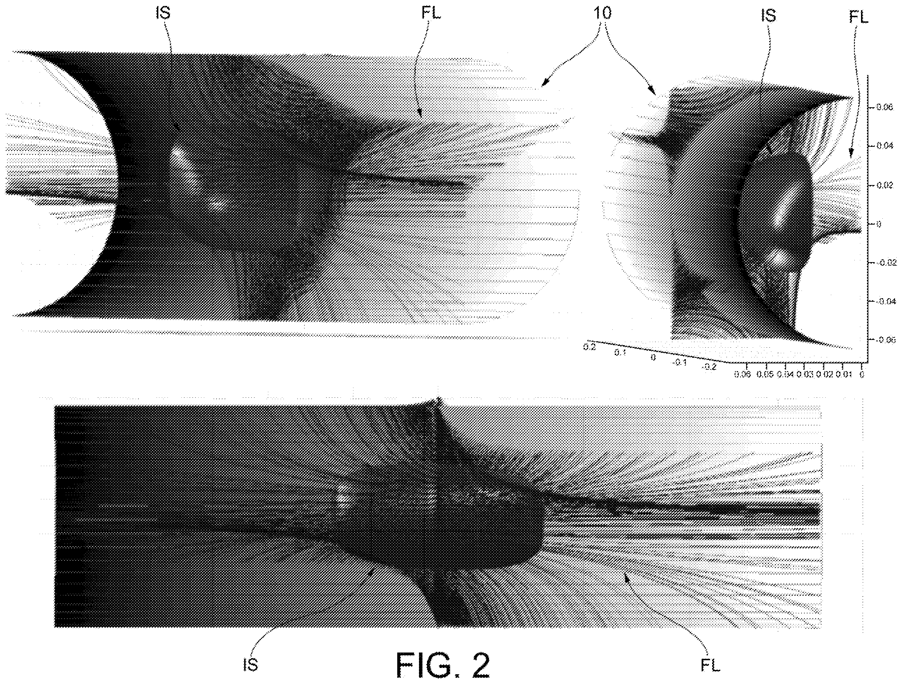

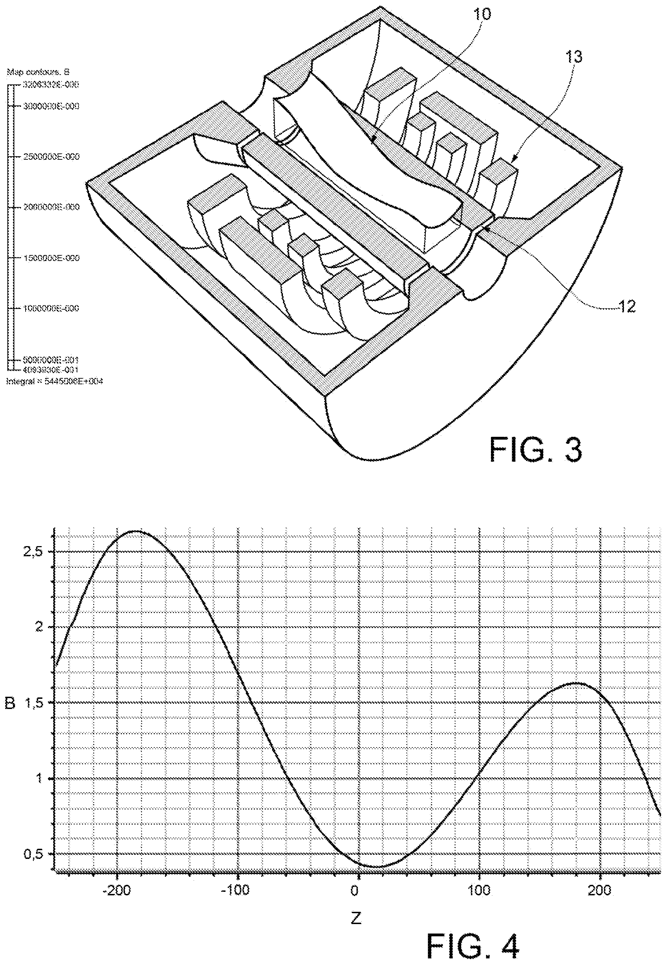

The electrons of the plasma are confined in a superposition of an axial component of the magnetic field (produced by the solenoids 13 or by permanent magnets) and of a radial component of the magnetic field produced by the multipole 12. This gives rise to a so-called B-minimum structure since the magnetic field has a minimum in the middle of the structure and from there it grows in all directions. Thus, a closed surface is created where the electron cyclotron resonance condition is satisfied. The electrons passing through this surface may be accelerated in a resonant manner. Furthermore, an elevated mirror ratio of the magnetic field results in long confinement times for the electrons of the plasma. These electrons may then pass many times through the resonance region, reach high energies, and ionize the atoms of the plasma, as well as the ions themselves, toward higher charge states, by means of successive single ionizations. The magnetic field of the B-minimum structure is shown in Fig. 2-4. In particular, Fig. 2 represents-according to different perspectives-a longitudinally sectioned view of a traditional cylindrical chamber, where IS indicates an isomagnetic surface and FL indicates the field lines of the magnetic induction vector. Fig. 3 represents the magnetic field on the longitudinal axis of the chamber produced by the solenoids 13, and Fig. 4 represents the modulus of the magnetic field on a longitudinal section of the chamber.

The ions in the plasma are not accelerated due to their high mass and remain thermal. These ions are therefore not confined by the magnetic field but by the spatial charge potential of the electrons.

The magnetic confinement, however, is not perfect and the electrons may leave the plasma, particularly in the axial direction. Since the plasma tends to remain neutral, the ions follow the electrons. By taking advantage of a suitable extraction geometry and applying a high voltage, the ions may be extracted from the ion source, as represented by reference 15 in Fig. 1.

The experimental results obtained by the X-ray imaging technique [1,2] and the selfconsistent simulations provide information on the plasma structure of the ECR sources (ECRIS) [3]. Both the experimental and the numerical results show that the microwave power deposition is not concentrated in the nucleus (central core) of the plasma as would be desirable to maximize the brilliance of the ion beam; instead a plasma "void" is often created along their central axis. The symmetry of the plasma chamber could be a major cause. In effect, in a cylindrical cavity resonator coupled through a rectangular aperture at the bottom of the chamber, eigenmodes often characterized by an off-axis field distribution are excited.

Furthermore, even the "aperture" coupling by means of a rectangular waveguide facing the cylindrical chamber (as commonly occurs in the ECRIS) suffers from an intrinsic mismatch, of both geometry and impedance.

In light of the above, a reworking of the plasma chamber and microwave launching system is a possible solution. G. Tornsi et al: "Non-Conventional Microwave Coupling of RF Power in ECRIS Plasmas", ICIS 2017 - 17th International Conference on Ion Sources, 16 October 2017 (2017-10-16) discloses a microwave resonator comprising a plasma chamber whose shape follows a magnetic field structure. US 7305935 B1 discloses a microwave launching device. V. Mironov et al: "Numerical model of electron cyclotron resonance ion source", Physical Review Special Topics - Accelerators and Beams, vol. 18, no. 12, 1 December 2015 (2015-12-01) discloses an electron cyclotron resonance ion source.

An object of this invention is to propose solutions for improving the wave-plasma coupling in an ECR ion source and for maximizing the absorption of the radiofrequency power in the plasma core.

According to the invention a microwave resonator according to claim 1 is provided.

In particular, wherein at said intermediate plane said chamber has a cross section of multi-lobed shape having a plurality of lobes identical to each other and in a number equal to twice the number of lobes of each end face.

Preferably, said chamber is formed as a single piece, in particular by means of an additive manufacturing technique. In this context, the microwave launching device may also be formed as a single piece with said chamber.

Specifically, the resonator further comprises an assembly of magnets or coils configured to generate the magnetic field with B-minimum geometry within the chamber. In the resonator according to the invention, in essence, the cylindrical symmetry used for the chambers of conventional resonators is abandoned in favor of a geometry that copies the three-dimensional structure of the plasma and, therefore, of the magnetic field. This configuration allows, compared to conventional resonators, a better coupling of the electromagnetic field, an improvement of the maximization of the brilliance of the ion beam, and an optimization of the confinement of the plasma.

The structure according to the invention also allows the use of microwave launching systems consisting of waveguides obtained in the same structure as the chamber, from which diffractive slots obtained in the walls of the plasma chamber are opened and allow a profound optimization also of the cooling systems and spaces in general. The slots (radiating slots) obtained along the waveguides allow high efficiency diffractive irradiation inside the plasma chamber, due to the fact that they allow a distributed injection of microwaves along the length of the chamber, instead of a localized injection at an end face of the chamber as occurs in conventional resonators.

Further features and advantages of the device according to the invention will become clearer from the following detailed description of an embodiment of the invention, made in reference to the accompanying drawings, provided purely for illustrative and non-limiting purposes, wherein:

Fig. 1 is a schematic representation of a conventional ion source;
Fig. 2 shows views in longitudinal section representing the magnetic field inside the source chamber of Fig. 1;
Fig. 3 is a graph representing the magnetic field on the longitudinal axis of the source chamber of Fig. 1;
Fig. 4 represents the magnetic field modulus on a longitudinal section of the source chamber of Fig. 1;
Fig. 5 and 6 are perspective views of a resonator according to the invention, respectively with and without a launching waveguide of the microwave;
Fig. 7 and 8 are front views respectively taken along the opposite ends of the resonator of Fig. 6;
Fig. 9 and 10 are front views respectively taken along the opposite ends of the resonator of Fig. 5;
Fig. 11 is a view in cross section taken at mid-length of the resonator of Fig. 6;
Fig. 12 is a view in cross section taken at mid-length of the resonator of Fig. 5; and
Fig. 13 is a cut-away view of an ion source wherein the resonator of Fig. 5 is installed.

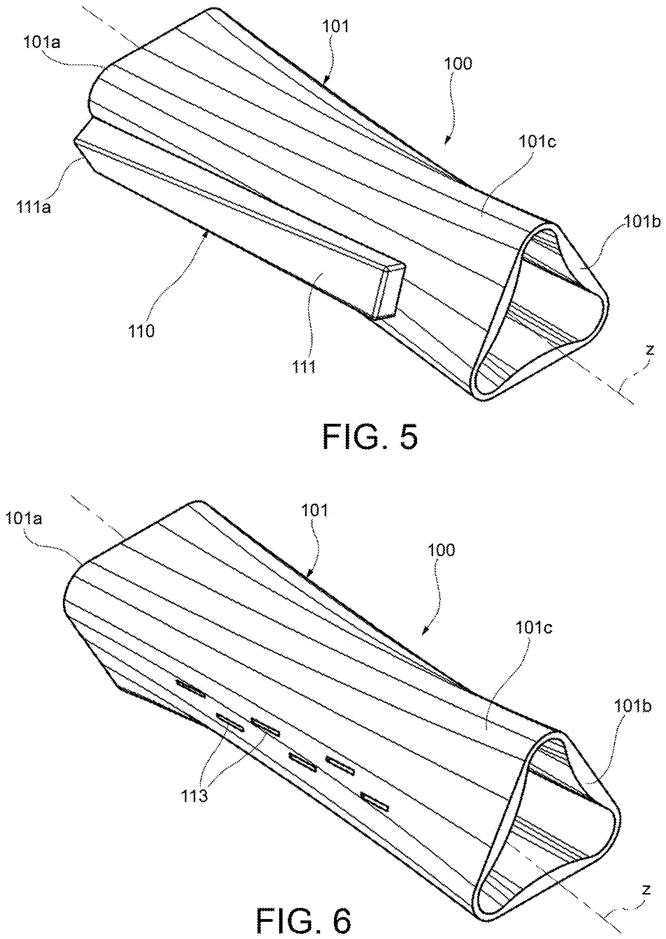

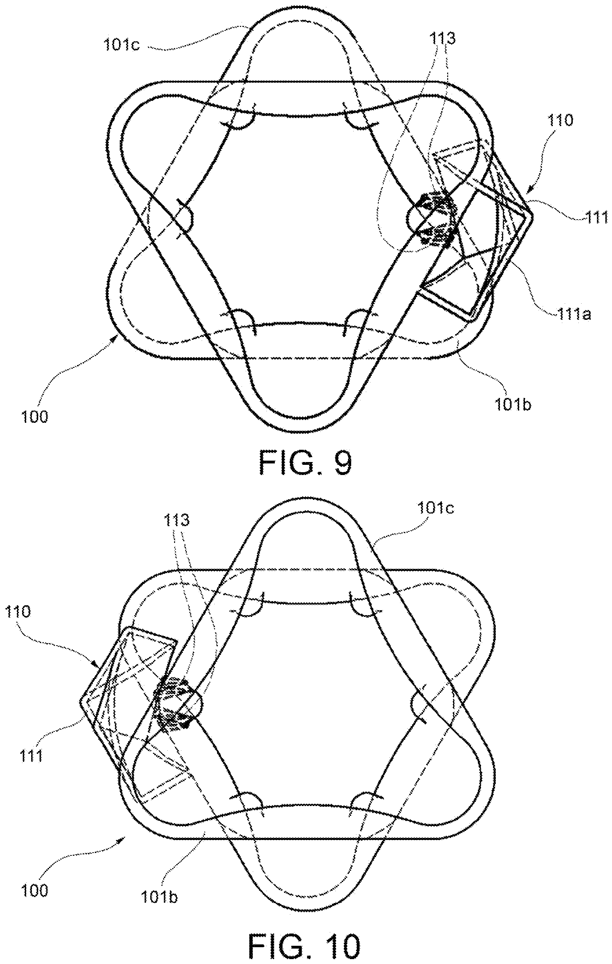

With reference to Fig. 5 to 13, a microwave resonator according to the invention is indicated collectively with 100.

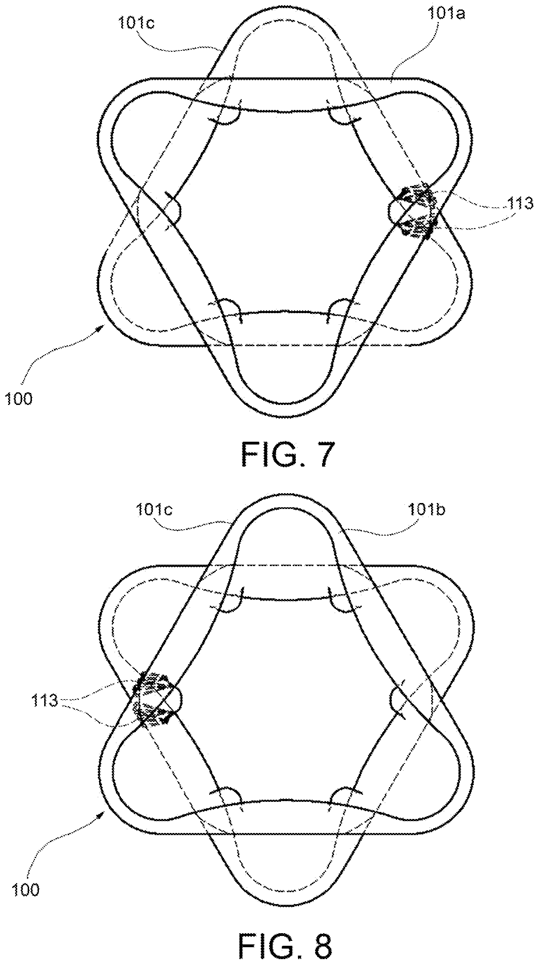

The resonator 100 comprises a chamber 101 made of metal material configured to contain a plasma. The chamber 101 comprises a first and a second end face, indicated respectively with 101a and 101b and shown in particular in Fig. 7-10, and a side wall 101c, which extends along a central axis z of the chamber between the first end face 101a and the second end face 101b.

At the first end face 101a, the chamber 101 has a cross section of multi-lobed shape having a symmetry of rotation about the central axis z. The number of lobes must be equal to half the number of poles of the magnet or coil assembly intended to generate the radial component of the magnetic field inside the chamber 101. In the illustrated example, the cross section of the first end face 101a of the chamber 101 has three lobes as the chamber 101 is intended to be associated with a hexapole such as the one described in reference to Fig. 1. Furthermore, the cross section of the first end face 101a tapers toward the second end face 101b.

At the second end face 101b, the chamber 101 has a cross section of multi-lobed shape identical to that of the first end face 101a and rotated by 180° relative thereto about the central axis z. Furthermore, the cross section of the second end face 101b tapers toward the first end face 101a.

Along the direction of the central axis z the shapes of the end faces 101a and 101b progressively merge with each other; in other words, these shapes combine to generate a shape resulting from their envelope. As a result of the tapering, at each intermediate plane along the direction z the contribution of a single shape is greater than that of the other depending on whether this intermediate plane is closer to one or the other.

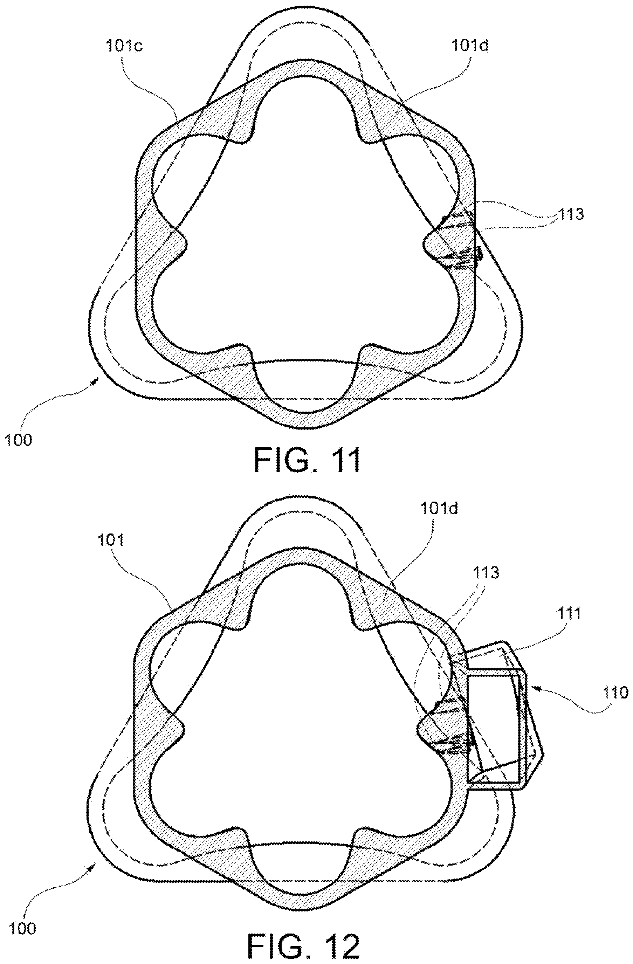

In an intermediate plane, i.e., a plane placed at mid-length (see Fig. 11 and 12), the contribution of the shape of the cross section of the first end face 101a is equal to the contribution of the shape of the cross section of the second end face 101b. Therefore, in this intermediate plane the chamber 101 has a cross section of multi-lobed shape 101d having a plurality of identical lobes and in a number equal to double the number of lobes of each end face.

With the geometry described above, the shape of the cavity resonator 100 follows the twisting magnetic structure of the B-minimum geometry and, therefore, the shape of the last iso-density surface of the electrons.

The chamber 101 is made in one piece and may be made by additive manufacturing.

The resonator 100 further comprises a microwave launching device 110 configured for the injection of microwaves into the chamber 101. The microwave launching device 110 comprises a waveguide 111 arranged on the side wall 101c of the chamber 101. The waveguide 111 has a substantially rectangular cross section and extends along the central axis z. For the purposes of this invention, "extending along the central axis" means that the waveguide 111 has an extending component parallel to the central axis z. As may be seen in the figures, however, the waveguide 111 develops according to a three-dimensional curve.

At one end of the waveguide 111 adjacent to the first end face 101a of the resonator 100 an input 111a for microwaves is made. The input 111a of the waveguide 111 may be arranged level with the first end face 101a of the resonator 100.

The waveguide 111 has an array of diffractive apertures or slots 113 interposed between the waveguide 111 and the chamber 101 and facing the interior of the chamber 101. In particular, the diffractive apertures 113 are obtained through the side wall 101c of the chamber 101. In other words, the waveguide 111 shares a wall, i.e., the one in which the diffractive apertures 113 are formed, with the chamber 101.

The microwave launching device 110 described above forms a slotted waveguide antenna. The design of a slotted waveguide is generally based on the procedure described by Elliott [4-6], according to which:

- the final end of the waveguide is a short circuit placed at a distance from the center of the last slot equal to a quarter of a "guided wavelength";
- the distance between the slots is equal to half the wavelength in the guide;
- the length of the slots should be about half the wavelength in free space;
- the width of the slots is much smaller than the wavelength in vacuum.

Thus, the resonant array of slots is obtained by making narrow apertures (relative to the wavelength in vacuum) on the wide wall of the rectangular waveguide, arranged in the longitudinal direction (parallel to the axis of the guide), spaced from each other by an amount equal to half the wavelength in the guide and placed alternately on either side with respect to the central longitudinal axis of the wide wall of the guide, with offset (distance between the centers of the slots and the longitudinal axis) equal on both sides.

The exact dimensions in each case must be optimized. In particular, the offset of the slots, i.e., their distance from the central axis of the wide wall of the slotted waveguide, determines the power levels of the side lobes irradiated by said slotted antenna.

The inventors have optimized the aforesaid features at the design stage to work in the 13.7-15.5 GHz frequency band.

Regarding the number of slots, several factors should be considered. In general, the fewer the number of slots the larger the bandwidth, but the efficiency of antennas with only 2 or 3 slots is usually too low.

Therefore, the optimal number of slots must be determined for each particular case. For example, the optimal number of slots may be estimated in order to minimize the reflection coefficient or to obtain a certain radiation pattern.

The optimal number of slots may be for example equal to 8, but this number (intended as the maximum) depends on the total length available for the plasma chamber of the resonator and therefore may be rescaled.

The microwave launching device 110 may be made in one piece with the chamber 101, for example by means of additive manufacturing.

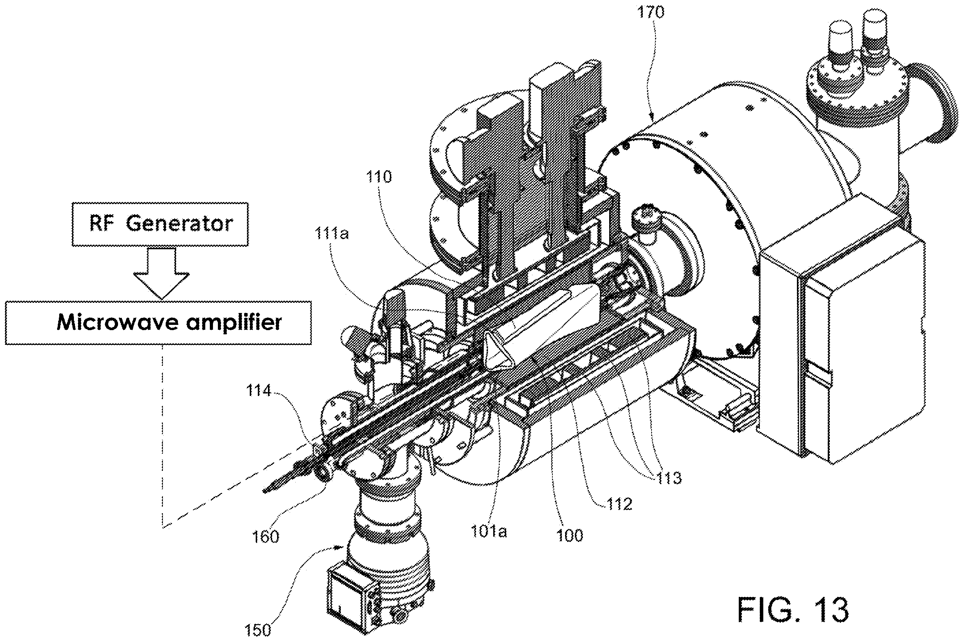

Fig. 13 shows an example of an ion source inside of which the resonator 100 described above is arranged.

Associated with the chamber 101 of the resonator 100 is an assembly of magnets or coils configured to generate the magnetic field with B-minimum geometry inside the chamber 101. This assembly of magnets comprises a multipole 112, in particular a hexapole, and a solenoid 113 configured to generate respectively the radial component and the axial component of the magnetic field inside the chamber 101. Reference 114 indicates a waveguide, in particular a waveguide with a standard rectangular section, configured to feed microwaves to the microwave launching device 110. One end of the power waveguide 114 is conventionally coupled to a radio frequency generator 141, via a microwave amplifier 142. At the other end, the power supply waveguide 114 is coupled to the input 111a of the waveguide 111 of the microwave launching device 110.

Fig. 13 also shows a vacuum pumping system 150 and a gas supply inlet 160 for supplying gas inside the chamber 101. Lastly, 170 shows an extraction system.

Bibliographical references

[1] R. Racz, D. Mascali, S. Biri et al. Plasma Sources Science and Technology 26 (7), 2017

[2] D. Mascali, G. Castro, S. Biri et al., Review of Scientific Instruments 87 (2): 02A510, February 2016

[3] D. Mascali, G. Torrisi, L. Neri, et al., Eur. Phys. J. D (2015) 69: 27

[4] R. S. Elliott and L. A. Kurtz, "The Design of Small Slot Arrays," IEEE Trans. Antennas Propagat., vol. 26, pp. 214-219, March 1978

[5] R. S. Elliott, "The Design of Traveling Wave Fed Longitudinal Shunt Slot Arrays," IEEE Trans. Antennas Propagat., vol. 27, no. 5, pp. 717- 720, September 1979

[6] R. S. Elliott, "An Improved Design Procedure for Small Arrays of Shunt Slots," IEEE Trans. Antennas Propagat., vol. 31, pp. 48-53, January 1983

**Claims**

1. A microwave resonator (100), comprising

   a chamber (101) made of metal material configured to contain electrons of a plasma confined in a B-minimum magnetic field generated within the chamber (101), said chamber comprising a first and a second end face (101a, 101b) and extending along a central axis (z) between said first and second end face, and
   a microwave launching device (110) configured for the injection of microwaves into said chamber,
   wherein, at the first end face (101a), said chamber has a cross section of multi-lobed shape tapering toward the second end face (101b),
   wherein, at the second end face (101b), said chamber has a cross section of multi-lobed shape identical to the shape of the cross section of the first end face (101a) and rotated by 180° relative to the first end face about the central axis (z), the cross section of the second end face (101b) tapering towards the first end face (101a), and
   wherein, at an intermediate plane, the shape of the cross section of the first end face (101a) merges with the shape of the cross section of the second end face (101b),
   **characterized in that** the microwave resonator (100) is configured to have a shape that follows the shape of the last iso-density surface of the electrons,
   wherein said microwave launching device comprises a waveguide (111) arranged on a side wall (101c) of said chamber and extending along said central axis, said waveguide having an array of diffractive apertures (113) interposed between the waveguide (111) and the chamber (101) and facing the inside of said chamber.

2. The resonator according to claim 1, wherein, at said intermediate plane, said chamber has a cross section of multi-lobed shape (101d) having a plurality of lobes identical to each other and in number equal to twice the number of lobes of each end face (101a, 101b).

3. The resonator according to any of the preceding claims, wherein said chamber is formed as a single piece.

4. The resonator according to claim 3, wherein said microwave launching device is formed as a single piece with said chamber.

5. The resonator according to any of the preceding claims, further comprising an assembly of magnets or coils (112, 113) configured to generate the magnetic field with B-minimum geometry within the chamber (101).

6. An ion source or plasma trap comprising a resonator according to any of the preceding claims.

**Patentansprüche**

1. Ein Mikrowellenresonator (100), umfassend

   eine Kammer (101) aus einem Metallmaterial, die so konfiguriert ist, dass sie Elektronen eines Plasmas enthält, das in einem B-Minimum-Magnetfeld eingeschlossen ist, das in der Kammer (101) erzeugt wird, wobei die genannte Kammer eine erste und eine zweite Endfläche (101a, 101b) umfasst und sich entlang einer Mittelachse (z) zwischen der ersten und der zweiten Endfläche erstreckt, und
   eine Mikrowellenabschussvorrichtung (110), die für die Einkopplung von Mikrowellen in die genannte Kammer konfiguriert ist,
   wobei die genannte Kammer an der ersten Endfläche (101a) einen Querschnitt mit einer Mehrfachlappenform aufweist, der sich zur zweiten Endfläche (101b) hin verjüngt,
   wobei die genannte Kammer an der zweiten Endfläche (101b) einen Querschnitt mit einer Mehrfachlappenform aufweist, die identisch mit der Form des Querschnitts der ersten Endfläche (101a) ist und um 180° relativ zur ersten Endfläche um die Mittelachse (z) gedreht ist, wobei sich der Querschnitt der zweiten Endfläche (101b) zur ersten Endfläche (101a) hin verjüngt, und
   wobei in einer Zwischenebene die Form des Querschnitts der ersten Endfläche (101a) in die Form des Querschnitts der zweiten Endfläche (101b) übergeht, **dadurch gekennzeichnet, dass** der Mikrowellenresonator (100) so konfiguriert ist, dass er eine Form aufweist, die der Form der letzten Isodichtefläche der Elektronen folgt,
   wobei die Mikrowellenabschussvorrichtung einen Wellenleiter (111) umfasst, der an einer Seitenwand (101c) der genannte Kammer angeordnet ist und sich entlang der Mittelachse erstreckt, wobei der Wellenleiter eine Anordnung von Beugungsöffnungen (113) aufweist, die zwischen dem Wellenleiter (111) und der Kammer (101) angeordnet sind und zum Inneren der genannte Kammer weisen.

2. Der Resonator nach Anspruch 1, wobei die genannte Kammer an der Zwischenebene einen Querschnitt mit einer mehrlappigen Form (101d) mit einer Vielzahl von Lappen aufweist, die identisch zueinander sind und deren Anzahl gleich der doppelten Anzahl der Lappen jeder Endfläche (101a, 101b) ist.

3. Der Resonator nach einem der vorhergehenden Ansprüche, wobei die genannte Kammer als ein einziges Stück ausgebildet ist.

4. Der Resonator nach Anspruch 3, wobei die genannte Mikrowellenabschussvorrichtung als ein einziges Stück mit der Kammer ausgebildet ist.

5. Der Resonator nach einem der vorhergehenden Ansprüche, weiter umfassend Anordnung von Magneten oder Spulen (112, 113), die so konfiguriert sind, dass sie das Magnetfeld mit B-minimaler Geometrie innerhalb der Kammer (101) erzeugen.

6. Ionenquelle oder Plasmafalle umfasst einen Resonator nach einem der vorhergehenden Ansprüche.


**Revendications**

1. Résonateur à micro-ondes (100), comprenant

une chambre (101) en matériau métallique configurée pour contenir les électrons d'un plasma confiné dans un champ magnétique minimum B généré à l'intérieur de la chambre (101), ladite chambre comprenant une première et une deuxième face d'extrémité (101a, 101b) et s'étendant le long d'un axe central (z) entre lesdites première et deuxième faces d'extrémité, et un dispositif de lancement de micro-ondes (110) configuré pour l'injection de micro-ondes dans ladite chambre,

dans laquelle, au niveau de la première face d'extrémité (101a), ladite chambre présente une section transversale de forme multilobée s'amincissant vers la deuxième face d'extrémité (101b),

dans laquelle, au niveau de la deuxième face d'extrémité (101b), ladite chambre présente une section transversale de forme multilobée identique à la section transversale de la première face d'extrémité (101a) et tournée de 180° par rapport à la première face d'extrémité autour de l'axe central (z), la section transversale de la deuxième face d'extrémité (101b) s'amincissant vers la première face d'extrémité (101a), et

dans lequel, à un plan intermédiaire, la forme de la section transversale de la première face d'extrémité (101a) se confond avec la forme de la section transversale de la deuxième face d'extrémité (101b),

**caractérisé en ce que** le résonateur à micro-ondes (100) est configuré pour avoir une forme qui suit la forme de la dernière surface d'iso-densité des électrons,

dans lequel ledit dispositif de lancement de micro-ondes comprend un guide d'ondes (111) disposé sur une paroi latérale (101c) de ladite chambre et s'étendant le long dudit axe central, ledit guide d'ondes ayant un réseau d'ouvertures diffractives (113) interposées entre le guide d'ondes (111) et la chambre (101) et faisant face à l'intérieur de ladite chambre.

2. Le résonateur selon la revendication 1, dans lequel, au niveau dudit plan intermédiaire, ladite chambre présente une section transversale de forme multilobée (101d) ayant une pluralité de lobes identiques entre eux et en nombre égal à deux fois le nombre de lobes de chaque face d'extrémité (101a, 101b).

3. Le résonateur selon l'une des revendications précédentes, dans lequel ladite chambre est formée d'une seule pièce.

4. Résonateur selon la revendication 3, dans lequel le dispositif de lancement des micro-ondes est formé d'une seule pièce avec ladite chambre.

5. Le résonateur selon l'une quelconque des revendications précédentes, comprenant en outre un assemblage d'aimants ou de bobines (112, 113) configuré pour générer le champ magnétique avec une géométrie B-minimum à l'intérieur de la chambre (101).

6. Source d'ions ou piège à plasma comprenant un résonateur selon l'une quelconque des revendications précédentes.

FIG. 1

FIG. 2

EP 4 097 791 B1

Map contours, B

FIG. 3

FIG. 4

FIG. 5

FIG. 6

FIG. 7

FIG. 8

FIG. 9

FIG. 10

101c

101d

113

100

**FIG. 11**

101d

101

113

111

110

100

**FIG. 12**

RF Generator

Microwave amplifier

FIG. 13

EP 4 097 791 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7305935 B1

### Non-patent literature cited in the description

- **G. TORNSI et al.** Non-Conventional Microwave Coupling of RF Power in ECRIS Plasmas. *ICIS 2017 - 17th International Conference on Ion Sources,* 16 October 2017
- **V. MIRONOV et al.** Numerical model of electron cyclotron resonance ion source. *Physical Review Special Topics - Accelerators and Beams,* 01 December 2015, vol. 18
- **R. RACZ ; D. MASCALI ; S. BIRI et al.** *Plasma Sources Science and Technology,* 2017, vol. 26 (7
- **D. MASCALI ; G. CASTRO ; S. BIRI et al.** *Review of Scientific Instruments,* February 2016, vol. 87 (2), 02A510
- **D. MASCALI ; G. TORRISI ; L. NERI et al.** *Eur. Phys. J. D,* 2015, vol. 69, 27
- **R. S. ELLIOTT ; L. A. KURTZ.** The Design of Small Slot Arrays. *IEEE Trans. Antennas Propagat.,* March 1978, vol. 26, 214-219
- **R. S. ELLIOTT.** The Design of Traveling Wave Fed Longitudinal Shunt Slot Arrays. *IEEE Trans. Antennas Propagat.,* September 1979, vol. 27 (5), 717-720
- **R. S. ELLIOTT.** An Improved Design Procedure for Small Arrays of Shunt Slots. *IEEE Trans. Antennas Propagat,* January 1983, vol. 31, 48-53